# EUROPEAN PATENT APPLICATION

(11) **EP 2 854 186 A1**
(43) Date of publication of application: **01.04.2015**
(21) Application number: 14186227.6
(22) Date of filing: 24.09.2014
(51) Int. Cl.: H01L 33/46, G02F 1/1335, H01L 33/50, H01L 33/48, H01L 33/60

(54) **Light source module, fabrication method therefor, and backlight unit including the same**

(30) Priority: 26.09.2013 KR 20130114736; 16.09.2014 KR 20140123053
(71) Applicant: Seoul Semiconductor Co., Ltd., Ansan-si, Gyeonggi-do 425-851 (KR)
(72) Inventor: Nam, Ki Bum, 425-851 Ansan-si, Gyeonggi-do (KR); Jung, Seoung Ho, 425-851 Ansan-si, Gyeonggi-do (KR); Han, Yu Dae, 425-851 Ansan-si, Gyeonggi-do (KR); Lee, Chung Hoon, 425-851 Ansan-si, Gyeonggi-do (KR); Choi, Hyuck Jung, 425-851 Ansan-si, Gyeonggi-do (KR)
(74) Representative: Stolmár & Partner

(57) **Abstract**

Disclosed are a light source module (100) having excellent luminous efficiency, a fabrication method therefor, and a slim backlight unit (BLU) including the same. The light source module (100) includes a light emitting diode (LED) chip (110) electrically connected to a substrate (140) through a lower surface thereof, a wavelength conversion layer (120) formed on the LED chip (110) and enclosing at least the light exit face of the LED chip (110), and a reflector (130) formed on a region of the LED chip excluding the light exit face.

## Description

### CROSS-REFERENCE TO RELATED APPLICATION

This application claims priority from and the benefit of Korean Patent Application No. 10-2013-0114736, filed on September 26, 2013, and Korean Patent Application No. 10-2014-0123053, filed on September 16, 2014, which is hereby incorporated by reference for all purposes as if fully set forth herein.

### BACKGROUND OF THE INVENTION

### FIELD OF THE INVENTION

The present invention relates to a light source module, a fabrication method therefor, and a backlight unit including the same, and more particularly, to a light source module having excellent luminous efficiency, a method of fabricating the same, and a slim backlight unit including the same.

### DESCRIPTION OF THE BACKGROUND

In general, backlight units are widely used to provide light to display devices, such as liquid crystal display (LCD) devices, or surface lighting devices.

Backlight units provided to LCD devices are mainly divided into a direct type and an edge type depending upon a position of light emitting devices.

Direct type backlight units have been mainly developed together with large screen LCDs of 20 inches or more and are characterized in that a plurality of light sources disposed under a diffusion plate directly emits light toward a front surface of an LCD panel. Such direct type backlight units are mainly used for large screen LCD devices requiring high luminance owing to higher luminous efficiency than the edge type backlight units.

Edge type backlight units are employed for relatively small-sized LCD devices such as monitors of laptop computers and desktop computers, and have excellent light uniformity, long lifespan, and an advantage for slimness of LCD devices.

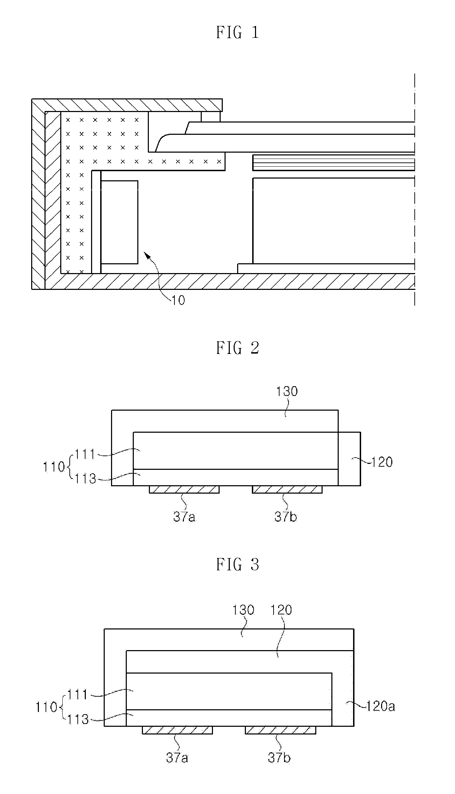

Figure 1 is a sectional view of a typical light emitting diode (LED) package and a backlight unit including the same. Referring to Figure 1, an LED package 10 is mounted on a side surface of a backlight unit in the related art.

In this case, on account of the height corresponding to the width of the LED package, there is a limitation in slimness of the backlight unit.

When the LED package has a decreased width to overcome such a limitation, current spreading deteriorates efficiency of the LED package.

As such, despite a limitation in achieving slimness of the backlight units due to the LED package as described above, users demand slimmer backlight units. Therefore, there is a need for edge type backlight units including a novel LED package.

### SUMMARY OF THE INVENTION

The present invention is aimed at providing a slim backlight unit of an edge type implemented by mounting a light emitting diode (LED) chip alongside a light guide plate.

In addition, the present invention is aimed at providing a light source module, a fabrication method therefor, and a backlight unit including the same, in which a light exit pathway is directed toward a light guide plate, by forming a wavelength conversion layer on a side surface of an LED chip facing toward the light guide plate, followed by forming a reflector on a region of the LED chip excluding the side surface thereof, thereby enhancing luminous efficiency of the LED chip when the LED chip is mounted alongside the light guide plate.

Further, the present invention is aimed at providing a light source module, a fabrication method therefor, and a backlight unit including the same, in which an underfill including a reflective material is formed between an LED chip and a substrate to prevent light generated from the LED chip from being emitted through other faces excluding a designated light exit face and concentrate the light on the light exit face, thereby enhancing luminous efficiency.

Furthermore, the present invention is aimed at providing a light source module, a fabrication method therefor, and a backlight unit including the same, in which an underfill is formed such that a reflective material is not coated onto a light exit face, thereby removing obstacles from a light exit pathway and decreasing a distance between an LED chip and a light guide plate to improve luminous efficiency.

In accordance with one aspect of the present invention, a light source module includes: a light emitting diode (LED) chip electrically connected to a substrate through a lower surface thereof and including a light exit face formed on one side surface thereof such that light of the LED chip is emitted therethrough; a wavelength conversion layer formed on the LED chip and enclosing at least the light exit face of the LED chip; and a reflector formed on a region of the LED chip excluding the light exit face.

The light source module may further include an underfill interposed between the substrate and the LED chip and including a reflective material.

The reflective material may include one material selected from the group consisting of TiO₂, SiO₂, ZrO₂, PbCO₃, PbO, Al₂O₃, ZnO, Sb₂O₃, and combinations thereof.

The underfill may include a fluorescent material.

The LED chip may be mounted on the substrate by flip-chip bonding or surface mount technology (SMT).

The LED chip may include a first semiconductor layer doped with a first conductive type impurity; an active layer formed under the first semiconductor layer; a second semiconductor layer doped with a second conductive type impurity and formed under the active layer; a first electrode electrically connected to the first semiconductor layer; a second electrode electrically connected to the second semiconductor layer; a first electrode pad electrically connected to the first electrode; and a second electrode pad electrically connected to the second electrode, wherein the LED chip may be electrically connected to the substrate through the first and second electrode pads.

In accordance with another aspect of the present invention, a backlight unit includes: a light guide plate; and a light source module placed on at least one side of the light guide plate and emitting light, wherein the light source module includes: a light emitting diode (LED) chip electrically connected to a substrate through a lower surface thereof and including a light exit face formed on one side surface thereof such that light of the LED chip is emitted therethrough; a wavelength conversion layer formed on the LED chip and enclosing at least the light exit face of the LED chip; and a reflector formed on a region of the LED chip excluding the light exit face.

The light source module may further include an underfill interposed between the substrate and the LED chip and including a reflective material.

The underfill may include a fluorescent material.

The LED chip may be mounted on the substrate by flip-chip bonding or surface mount technology (SMT).

In accordance with a further aspect of the present invention, a method of fabricating a light source module includes: fabricating a light emitting diode (LED) chip including a light exit face formed on one side surface thereof such that light of the LED chip is emitted therethrough; forming a wavelength conversion layer on the LED chip to enclose at least the light exit face of the LED chip; and forming a reflector on a region of the LED chip excluding the light exit face.

Forming the reflector may include: forming the reflector on an upper surface and a side surface of the LED chip; and exposing the wavelength conversion layer by removing the reflector from a region corresponding to the light exit face when the reflector is formed on the light exit face.

Exposing the wavelength conversion layer may include removing the reflector from the region corresponding to the light exit face by fly cutting.

The method may further include forming an underfill including a reflective material between the substrate and the LED chip after forming the reflector.

Forming the underfill may include forming a dam placed on the substrate to adjoin the light exit face of the LED chip; injecting the underfill into a region between the substrate and the LED chip; and removing the dam after forming the underfill.

The method may further include electrically connecting the LED chip to a substrate, wherein the LED chip may be mounted on the substrate by flip-chip bonding or surface mount technology (SMT).

Fabricating the LED chip may include: forming a first semiconductor layer doped with a first conductive type impurity; forming an active layer under the first semiconductor layer; forming a second semiconductor layer doped with a second conductive type impurity under the active layer; forming a first electrode electrically connected to the first semiconductor layer; forming a second electrode electrically connected to the second semiconductor layer; forming a first pad electrically connected to the first electrode; and forming a second pad electrically connected to the second electrode.

According to embodiments of the invention, an LED chip is mounted alongside a light guide plate, thereby providing a slim backlight unit of an edge type.

In addition, according to the embodiments of the invention, a light exit pathway is directed toward a light guide plate by forming a wavelength conversion layer on a side surface of an LED chip facing toward the light guide plate, followed by forming a reflector on a region of the LED chip excluding the side surface thereof, thereby enhancing luminous efficiency of the LED chip when the LED chip is mounted alongside the light guide plate.

Further, according to the embodiments of the invention, an underfill including a reflective material is formed between the LED chip and the substrate to prevent light generated from the LED chip from being emitted through other faces thereof excluding a designated light exit face and concentrating the light on the light exit face, thereby enhancing luminous efficiency.

Furthermore, according to the embodiments of the invention, the underfill is formed such that a reflective material is not coated onto the light exit face, thereby removing obstacles from a light exit pathway and decreasing a distance between an LED chip and a light guide plate to improve luminous efficiency.

### BRIEF DESCRIPTION OF THE DRAWINGS

The above and other aspects, features, and advantages of the present invention will become apparent from the detailed description of the following embodiments in conjunction with the accompanying drawings, in which:
Figure 1 is a sectional view of a light emitting diode package and a backlight unit including the same in the related art;
Figures 2 to 5 are sectional views of light source modules according to embodiments of the present invention;
Figure 6(a) is a plan view of a LED chip shown in Figures 2 to 5;
Figure 6(b) is a sectional view of the LED chip taken along line I-I' shown in Figure 6(a);
Figure 7 is an exploded perspective view of a display device including a backlight unit according to one embodiment of the present invention;
Figure 8 is a sectional view of the display device taken along line II-II' shown in Figure 7; and
Figures 9 to 11 show a fabrication process for a light source module according to one embodiment of the present invention.

### DETAILED DESCRIPTION OF THE INVENTION

Hereinafter, exemplary embodiments of the present invention will be described in detail with reference to the accompanying drawings. The following embodiments are provided by way of examples so as to fully convey the spirit of the present invention to those skilled in the art. Accordingly, the present invention is not limited to the embodiments disclosed herein and may also be implemented in different forms. In addition, shapes of elements may be exaggerated in the drawings. Throughout the specification, like reference numerals denote like elements having the same or similar functions. Modifications of elements falling within the spirit and scope of the present invention do not include restrictive meanings, are provided for clearly representing the spirit of the present invention, and can be restricted only by the appended claims.

Hereinafter, embodiments of the present invention will be specifically described with reference to the accompanying drawings such that those skilled in the art to which the present invention pertains can readily carry out the present invention.

Figures 2 to 5 are sectional views of light source modules according to embodiments of the invention.

Referring to Figures 2 to 5, a light source module 100 according to one embodiment of the invention includes a light emitting diode (LED) chip 110, a wavelength conversion layer 120, and a reflector 130.

The LED chip 110 includes a growth substrate 111 and a semiconductor stack 113. The LED chip 110 may be electrically connected to a substrate 140 by direct flip-chip bonding or surface mount technology (SMT). At this time, electrode pads 37a, 37b exposed on a lower surface of the LED chip 110 are electrically connected to substrate pads 141a, 141b through bumps 150a, 150b, respectively. Since the light source module 100 does not use wires, a molding component is not required to protect the wires, and portions of the wavelength conversion layer 120 need not be removed in order to expose bonding pads. Accordingly, the flip-chip type LED chip 110 employed for the present invention can achieve less color deviation and luminance unevenness than those of LED chips using bonding wires and makes it possible to simplify a module fabrication process.

The wavelength conversion layer 120 covers the LED chip 110. The LED chip 110 includes one side surface through which light is emitted, that is, a light exit face. The wavelength conversion layer 120 may enclose at least the light exit face and may also enclose an upper surface and side surfaces of the LED chip 110. That is, the wavelength conversion layer may be formed only on the light exit face, or on the light exit face, the upper surface, and some of the side surfaces of the LED chip 110. Alternatively, the wavelength conversion layer may also be formed on the upper surface and all of the side surfaces of the LED chip 110 including the light exit face. In addition, the wavelength conversion layer 120 may be formed of a fluorescent material capable of converting a wavelength of light emitted from the LED chip 110. The wavelength conversion layer 120 may be coated to a predetermined thickness onto the LED chip 110 to cover the upper and side surfaces of the LED chip 110. When the wavelength conversion layer 120 covers the upper and side surfaces of the LED chip, a thickness of a region covering the upper surface may be the same as or different from that of a region covering the side surfaces. In addition, a region covering the light exit face may have a different thickness than that of a region covering the upper and side surfaces excluding the light exit face.

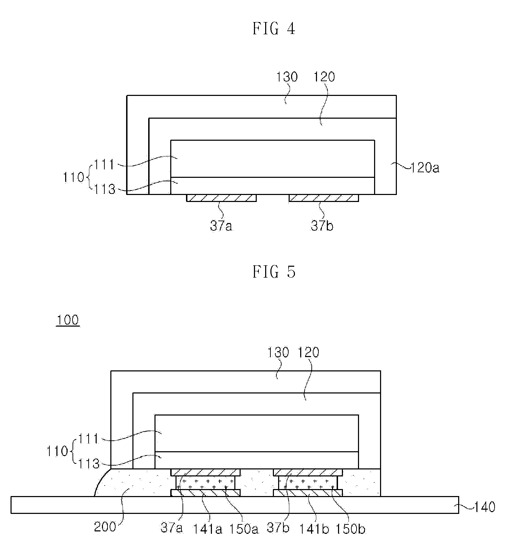

The reflector 130 is formed on a region of the LED chip 110 excluding the surface defined as the light exit face. At this time, the reflector 130 may be formed directly on the LED chip 110 or on another element interposed therebetween. That is, the reflector 130 may be formed directly on the LED chip 110 as shown in Figure 2, or on the wavelength conversion layer 120 formed on the LED chip 110, as shown in Figures 3 and 4 according to embodiments.

The reflector 130 serves to reflect light toward the light exit face. That is, the reflector formed on the region of the LED chip 110 excluding the light exit face serves to guide light toward one side surface of the light source module 100 so as to emit the light therethrough.

The substrate 140 includes the substrate pads 141a, 141b electrically connected to the LED chip 110, and the bumps 150a, 150b are placed on the substrate pads 141a, 141b, respectively. Although not particularly limited, the substrate 140 may be, for example, a metal printed circuit board (PCB) advantageous for heat dissipation. The substrate 140 may be a bar type substrate having major and minor axes.

An underfill 200 is interposed between the LED chip 110 and the substrate 140. The underfill 200 serves to reflect light generated from the LED chip 110, thereby enhancing luminous efficiency. In addition, the underfill 200 serves to prevent moisture infiltration between the LED chip 110 and the substrate 140. The underfill 200 includes a reflective material. For example, the underfill 200 may include a resin and a reflective material within the resin, and the reflective material may include one material selected from the group consisting of TiO₂, SiO₂, ZrO₂, PbCO₃, PbO, Al₂O₃, ZnO, Sb₂O₃, and combinations thereof. The underfill 200 is formed up to a region aligned with one surface of the LED chip 110 defined as the light exit face. Although not particularly limited, the underfill 200 may be formed by dispensing. The underfill 200 may further include a fluorescent material (not shown). The underfill 200 may have predetermined adhesive strength.

As such, the light source module 100 according to the embodiment of the invention can concentrate light on a side surface thereof using the reflector 130 and the underfill 200 while minimizing light loss, thereby maximizing luminous efficiency.

In addition, the LED chip 110 is electrically connected to the substrate 140 by direct flip-chip bonding or SMT, whereby the light source module 100 can achieve high efficiency and compactness, as compared with the typical light source module of a package type using wires.

Further, the light source module 100 can be made slimmer than a typical package type light source module mounted on a side surface of a light guide plate.

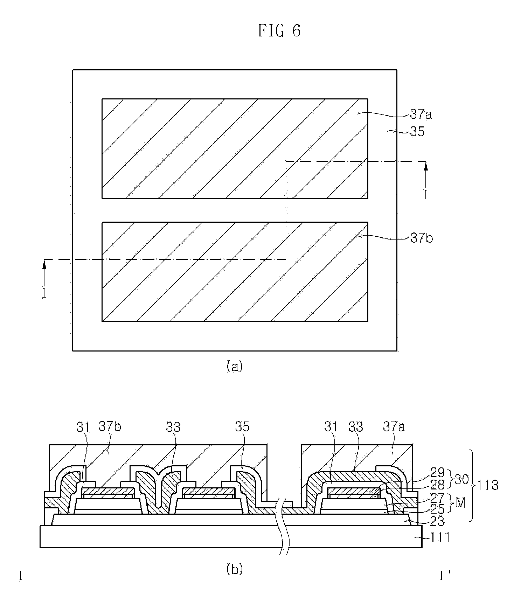

The structure of the LED chip 110 will be described in more detail with reference to Figures 6(a) and 6(b).

Figure 6(a) is a plan view of the LED chip shown in Figure 5, and Figure 6(b) is a sectional view of the LED chip taken along line I-I' shown in Figure 6(a).

Referring to Figures 6(a) and 6(b), a light emitting diode (LED) chip according to the invention may include a growth substrate 111 and a semiconductor stack 113.

The semiconductor stack 113 includes a first semiconductor layer 23 formed on the growth substrate 111 and doped with a first conductive type impurity, and a plurality of mesas M separated from each other on the first semiconductor layer 23.

Each of the plural mesas M includes an active layer 25 and a second semiconductor layer 27 doped with a second conductive type impurity. The active layer 25 is interposed between the first and second semiconductor layers 23, 27. Reflective electrodes 30 are placed on the plural mesas M, respectively.

The plural mesas M may have an elongated shape and extend parallel to each other in one direction as shown in the drawings. Such a shape makes it simple to form the same shape of plural mesas M on a plurality of chip regions of the growth substrate 111.

Although the reflective electrodes 30 may be formed on the respective mesas M after the plural mesas M are formed, the present invention is not limited thereto. Alternatively, the reflective electrodes 30 may be formed in advance on the second semiconductor layer 27 before the mesas M are formed after growth of the second semiconductor layer 27. The reflective electrodes 30 cover substantially overall upper surfaces of the mesas M and have substantially the same shape as that of a plane of the mesas M.

The reflective electrodes 30 include a reflective layer 28 and may further include a barrier layer 29. The barrier layer 29 may cover an upper surface and side surfaces of the reflective layer 28. For example, the barrier layer 29 may be formed to cover the upper surface and the side surfaces of the reflective layer 28 by forming a pattern of the reflective layer 28, followed by forming the barrier layer 29 on the pattern. By way of example, the reflective layer 28 may be formed by depositing Ag, Ag alloys, Ni/Ag, NiZn/Ag, or TiO/Ag, followed by patterning. The barrier layer 29 may be formed of Ni, Cr, Ti, Pt, Rd, Ru, W, Mo, TiW, or a composite layer thereof, and prevents diffusion or contamination of metallic materials in the reflective layer.

After the plural mesas M are formed, an edge of the first semiconductor layer 23 may also be subjected to etching. As a result, an upper surface of the substrate 21 may be exposed. A side surface of the first semiconductor layer 23 may also be formed.

The LED chip according to the invention further includes a lower insulation layer 31 to cover the plural mesas M and the first semiconductor layer 23. The lower insulation layer 31 has openings in specific regions thereof to allow electrical connection to the first and second semiconductor layers 23, 27. For example, the lower insulation layer 31 may have openings that expose the first semiconductor layer 23 and openings that expose the reflective electrodes 30.

The openings may be placed between the mesas M and near an edge of the substrate 21, and may have an elongated shape extending along the mesas M. In addition, the openings may be restrictively placed on the mesas M to be biased to the same ends of the mesas.

The LED chip according to the invention further includes a current spreading layer 33 formed on the lower insulation layer 31. The current spreading layer 33 covers the plural mesas M and the first semiconductor layer 23. The current spreading layer 33 has openings placed above the respective mesas M such that the reflective electrodes are exposed therethrough. The current spreading layer 33 may form ohmic contact with the first semiconductor layer 23 through the openings of the lower insulation layer 31. The current spreading layer 33 is electrically insulated from the plural mesas M and the reflective electrodes 30 by the lower insulation layer 31.

The openings of the current spreading layer 33 have a larger area than those of the lower insulation layer 31 so as to prevent the current spreading layer 33 from contacting the reflective electrodes 30.

The current spreading layer 33 is formed over a substantially overall upper area of the substrate 31 except for the openings thereof. Accordingly, current can be easily dispersed through the current spreading layer 33. The current spreading layer 33 may include a highly reflective metal layer, such as an Al layer, and the highly reflective metal layer may be formed on a bonding layer, such as Ti, Cr, Ni or the like. In addition, a protective layer having a monolayer or composite layer structure of Ni, Cr or Au may be formed on the highly reflective metal layer. The current spreading layer 33 may have a multilayer structure of, for example, Ti/Al/Ti/Ni/Au.

The LED chip according to the invention further includes an upper insulation layer 35 formed on the current spreading layer 33. The upper insulation layer 35 has openings that expose the current spreading layer 33 and openings that expose the reflective electrodes 30.

The upper insulation layer 35 may be formed using an oxide insulation layer, a nitride insulation layer, a mixed layer or an alternating layer of these insulation layers, or polymer such as polyimide, Teflon, Parylene, or the like.

First and second electrode pads 37a, 37b are formed on the upper insulation layer 35. The first electrode pad 37a is connected to the current spreading layer 33 through the openings of the upper insulation layer 35, and the second electrode pad 37b is connected to the reflective electrodes 30 through the openings of the upper insulation layer 35. The first and second electrode pads 37a, 37b may be used as pads for connection of bumps for mounting the LED chip on a circuit board, or pads for SMT.

The first and second electrode pads 37a, 37b may be formed simultaneously by the same process, for example, photolithography and etching, or lift-off technology. The first and second electrode pads 37a, 37b may include a bonding layer formed of, for example, Ti, Cr, Ni, or the like, and a highly conductive metal layer formed of Ag, Au, and the like. The first and second electrode pads 37a, 37b may be formed such that ends thereof are placed on the same plane, and the LED chip may be accordingly bonded to a conductive pattern, formed at the same height on the substrate, by flip-chip bonding.

The LED chip is completely fabricated by dividing the growth substrate 111 into individual LED chip units. The growth substrate 111 may also be removed from the LED chip before or after being divided into the individual LED chip units.

As such, the LED chip according to the present invention, which is directly bonded to the substrate by flip-chip bonding, has advantages of achieving high efficiency and compactness, as compared with the typical light emitting device of a package type.

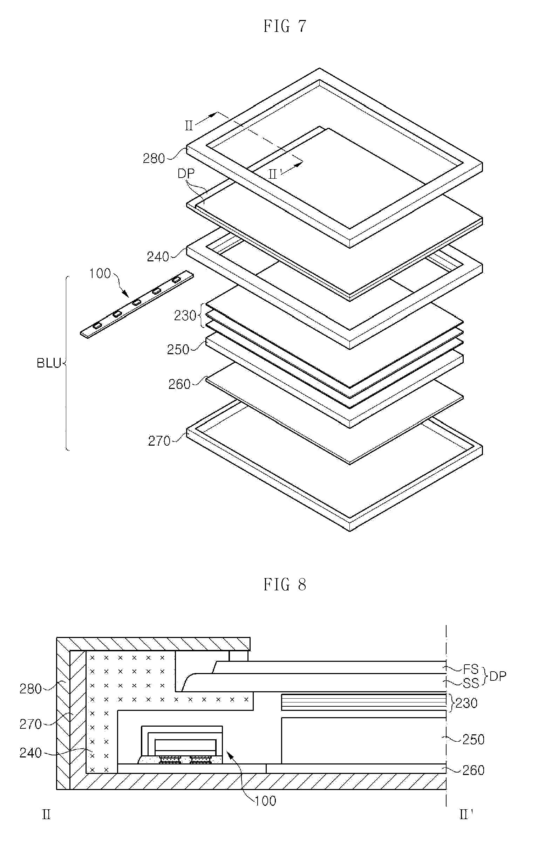

Figure 7 is an exploded perspective view of a display device including a backlight unit according to one embodiment of the present invention, and Figure 8 is a sectional view of the display device taken along line II-II' shown in Figure 7.

Referring to Figures 7 and 8, the display device according to the invention includes a display panel DP for displaying images, a backlight unit BLU disposed at the rear side of the display panel DP and emitting light, a frame 240 supporting the display panel DP and receiving the backlight unit BLU, and a top cover 280 surrounding the display panel DP.

The display panel DP includes a color filter substrate FS and a thin film transistor (TFT) substrate SS assembled to each other to face each other while maintaining a uniform cell gap. The display panel DP may further include a liquid crystal layer between the color filter substrate FS and the thin film transistor substrate SS depending upon a type thereof.

Although not shown in detail, the thin film transistor substrate SS includes a plurality of gate lines and data lines, which cross each other to define pixels therebetween, and a thin film transistor placed in each of crossing regions therebetween and connected to a pixel electrode mounted in each of the pixels in one-to-one correspondence. The color filter substrate FS includes R, G and B color filters corresponding to the respective pixels, a black matrix disposed along the periphery of the substrate and shielding the gate lines, data lines and thin film transistors, and a common electrode covering all of these components. Here, the common electrode may be formed on the thin film transistor substrate SS.

The backlight unit BLU supplies light to the display panel DP, and includes a lower cover 270 partially open at an upper side thereof, a light source module 100 disposed on one side within the lower cover 270, and a light guide plate 250 disposed parallel to the light source module 100 to convert point light into surface light. In the related art, the light source module 100 is usually disposed on an inner side surface of the lower cover 270. In this case, due to the width of the light source module 100, there is a limitation in reducing the height of the backlight unit or the display panel including the backlight unit. According to the present invention, the light source module 100 is placed on the bottom surface within the lower cover 270, thereby making the backlight unit or the display panel including the backlight unit slimmer than in the related art. The light source module 100, placed on the bottom surface within the lower cover 270, can be illustrated as being disposed parallel to the light guide plate 250, according to descriptions thereof.

In addition, the backlight unit BLU according to the invention further includes optical sheets 230 placed on the light guide plate 250 to diffuse and collect light, and a reflective sheet 260 placed below the light guide plate 250 to reflect light, which travels towards the lower portion of the light guide plate 250, toward the display panel DP.

Herein, detailed descriptions of the light source module 100 will not omitted. Refer to Figure 5 for details thereof.

The light source module 100 is fabricated by directly mounting LED chips on a substrate by flip-chip bonding or SMT, followed by forming underfills including reflective fillers between the substrate and the LED chips.

Accordingly, the light source module 100 according to the present invention is advantageous for slimness of the backlight unit and capable of maximizing luminous efficiency by concentrating light on a side thereof using the reflector and the underfills while minimizing light loss.

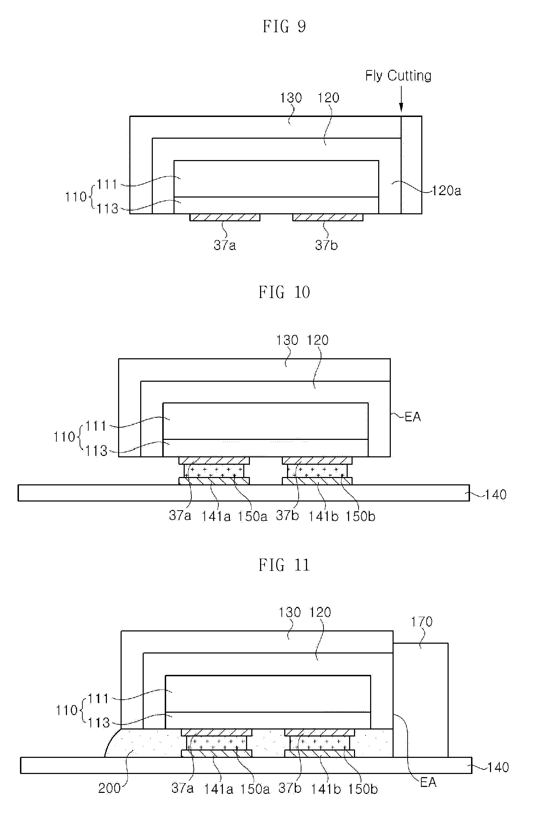

Figures 9 to 11 show a fabrication process for a light source module according to one embodiment of the present invention.

Referring to Figures 9 to 11, the fabrication process for the light source module includes fabricating an LED chip. In this operation, an LED chip 110 is first fabricated.

The LED chip 110 may be fabricated by forming a semiconductor stack 113 on a growth substrate 111. The LED 110 may be formed on a lower portion thereof with electrode pads 37a, 37b. Features of the light source module are the same as those of the light source module shown in Figures 2 to 5. Accordingly, like features are denoted by like reference numerals and will be briefly described in relation to the fabrication process without providing detailed descriptions thereof.

The fabrication of the LED chip includes forming a first semiconductor layer doped with a first conductive type impurity, forming an active layer under the first semiconductor layer, and forming a second semiconductor layer doped with a second conductive type impurity under the active layer. Thereafter, a first electrode is formed to be electrically connected to the first semiconductor layer, a second electrode is formed to be electrically connected to the second semiconductor, and first and second pads are formed to be electrically connected to the first and second electrodes, respectively.

Next, in operation of forming a wavelength conversion layer, a wavelength conversion layer 120 is formed to enclose at least a light exit face of the LED chip.

Then, in operation of forming a reflector, the reflector is formed on a region of the LED chip excluding the light exit face.

The reflector may be formed directly on the LED chip, or on another element such as the wavelength conversion layer 120 formed on the LED chip according to embodiments. When the reflector is formed on the light exit face, the wavelength conversion layer is exposed by removing the reflector from a region corresponding to the light exit face.

The exposed wavelength conversion layer 120 corresponds to the light exit face EA of the LED chip 110. Although not particularly limited, fly cutting may be used to remove the reflector 130.

The fabrication process for the light source module according to the embodiment of the invention further includes electrically connecting the LED chip to a substrate. In this operation, the electrode pads 37a, 37b of the LED chip 110 are connected to substrate pads 141a, 141b of a substrate 140, respectively. At this time, the LED chip 110 may be directly electrically connected to the substrate 140 by flip-chip bonding or surface mount technology (SMT). Here, bumps 150a, 150b are interposed between the substrate pads 141a, 141b and the electrode pads 37a, 37b, respectively.

According to the embodiment of the invention, the operations of forming the wavelength conversion layer and the reflector and the operation of electrically connecting the LED chip to the substrate may be performed in a different order. That is, the LED chip may be electrically connected to the substrate before or after the wavelength conversion layer and the reflector are formed on the LED chip.

The fabrication process for the light source module according to the embodiment of the invention further includes forming an underfill 200 between the substrate 140 and the LED chip 110. Specifically, a dam 170 is formed on a surface corresponding to the light exit face EA of the LED chip 110. The dam 170 contacts the light exit face EA of the LED chip 110. The dam 170 is placed to adjoin the substrate 140. The dam 170 may be formed on the substrate 140 by a frame structure including photoresist or adhesives. The underfill is injected into a region between the substrate and the LED chip after the dam 170 is formed. In this case, the dam 170 serves to restrict a region in which the underfill 200 will be formed. Particularly, the dam 170 prevents the underfill 200 from extending to the light exit face EA. The dam 170 may be removed by etching or other physical methods after the underfill 200 is formed.

The underfill 200 serves to reflect light generated from the LED chip 110, thereby enhancing luminous efficiency, and to prevent infiltration of moisture. The underfill 200 includes a reflective material. For example, the underfill 200 may include a resin and a reflective material within the resin, and the reflective material may include one material selected from the group consisting of TiO₂, SiO₂, ZrO₂, PbCO₃, PbO, Al₂O₃, ZnO, Sb₂O₃, and combinations thereof. The dam 170 allows the underfill 200 to be formed up to a region aligned with the light exit face EA. Although not particularly limited, the underfill 200 may be formed by dispensing. The underfill 200 may further include a fluorescent material (not shown). The underfill 200 may have predetermined adhesive strength.

As described above, the light source module according to the embodiment of the invention can concentrate light on a side thereof using the reflector 130 and the underfill 200 while minimizing light loss, thereby maximizing luminous efficiency.

In addition, the light source module according to the invention, in which the LED chip 110 is electrically connected to the substrate 140 by direct flip-chip bonding or SMT, can achieve high efficiency and compactness, as compared with the typical light source module of a package type using wires.

While various embodiments of the present invention have been described, the present invention is not limited to a particular embodiment. In addition, the elements illustrated in the specific embodiment may be used for other embodiments in the same or similar way, without departing from the spirit and the scope of the present invention.

### <List of Reference Numerals>

100: Light source module
110: Light emitting diode chip
120: Wavelength converter
130: Reflector
140: Substrate
200: Underfill

## Claims

1. A light source module comprising:
a light emitting diode (LED) chip electrically connected to a substrate through a lower surface thereof and including a light exit face formed on one side surface thereof such that light of the LED chip is emitted therethrough;
a wavelength conversion layer formed on the LED chip and enclosing at least the light exit face of the LED chip; and
a reflector formed on a region of the LED chip excluding the light exit face.

2. The light source module of claim 1, further comprising:
an underfill interposed between the substrate and the LED chip and comprising a reflective material.

3. The light source module of claim 2, wherein the reflective material comprises one material selected from the group consisting of TiO₂, SiO₂, ZrO₂, PbCO₃, PbO, Al₂O₃, ZnO, Sb₂O₃, and combinations thereof.

4. The light source module of claim 2, wherein the underfill comprises a fluorescent material.

5. The light source module of claim 1, wherein the LED chip is mounted on the substrate by flip-chip bonding or surface mount technology (SMT).

6. The light source module of claim 1, wherein the LED chip comprises:
a first semiconductor layer doped with a first conductive type impurity;
an active layer formed under the first semiconductor layer;
a second semiconductor layer doped with a second conductive type impurity and formed under the active layer;
a first electrode electrically connected to the first semiconductor layer;
a second electrode electrically connected to the second semiconductor layer;
a first electrode pad electrically connected to the first electrode; and
a second electrode pad electrically connected to the second electrode,
wherein the LED chip is electrically connected to the substrate through the first and second electrode pads.

7. A backlight unit comprising:
a light guide plate; and
a light source module placed on at least one side of the light guide plate and emitting light,
wherein the light source module comprises:
a light emitting diode (LED) chip electrically connected to a substrate through a lower surface thereof and including a light exit face formed on one side surface thereof such that light of the LED chip is emitted therethrough;
a wavelength conversion layer formed on the LED chip and enclosing at least the light exit face of the LED chip; and
a reflector formed on a region of the LED chip excluding the light exit face.

8. The backlight unit of claim 7, wherein the light source module further comprises an underfill interposed between the substrate and the LED chip and comprising a reflective material.

9. The backlight unit of claim 8, wherein the underfill comprises a fluorescent material.

10. The backlight unit of claim 7, wherein the LED chip is mounted on the substrate by flip-chip bonding or surface mount technology (SMT).

11. A method of fabricating a light source module, comprising:
fabricating a light emitting diode (LED) chip including a light exit face formed on one side surface thereof such that light of the LED chip is emitted therethrough;
forming a wavelength conversion layer on the LED chip to enclose at least the light exit face of the LED chip; and
forming a reflector on a region of the LED chip excluding the light exit face.

12. The method of claim 11, wherein forming the reflector comprises:
forming the reflector on an upper surface and a side surface of the LED chip; and
exposing the wavelength conversion layer by removing the reflector from a region corresponding to the light exit face when the reflector is formed on the light exit face.

13. The method of claim 12, wherein exposing the wavelength conversion layer comprises removing the reflector from the region corresponding to the light exit face by fly cutting.

14. The method of claim 11, further comprising:
forming an underfill comprising a reflective material between the substrate and the LED chip after forming the reflector.

15. The method of claim 14, wherein forming the underfill comprises:
forming a dam placed on the substrate to adjoin the light exit face of the LED chip;
injecting the underfill into a region between the substrate and the LED chip; and
removing the dam after forming the underfill.

16. The method of claim 11, further comprising:
electrically connecting the LED chip to a substrate,
wherein the LED chip is mounted on the substrate by flip-chip bonding or surface mount technology (SMT).

17. The method of claim 11, wherein fabricating the LED chip comprises:
forming a first semiconductor layer doped with a first conductive type impurity;
forming an active layer under the first semiconductor layer;
forming a second semiconductor layer doped with a second conductive type impurity under the active layer;
forming a first electrode electrically connected to the first semiconductor layer;
forming a second electrode electrically connected to the second semiconductor layer;
forming a first pad electrically connected to the first electrode; and
forming a second pad electrically connected to the second electrode.
